# EUROPÄISCHE PATENTSCHRIFT

(11) **EP 1 891 180 B1**
(45) Veröffentlichungstag und Bekanntmachung des Hinweises auf die Patenterteilung: **29.08.2018**
(21) Anmeldenummer: 06753605.2
(22) Anmeldetag: 15.05.2006
(51) Int. Cl.: C09K 11/06, H01L 51/50, H05B 33/12

(54) **LÖSUNGEN ORGANISCHER HALBLEITER**
ORGANIC SEMICONDUCTOR SOLUTIONS
SOLUTIONS DE SEMICONDUCTEURS ORGANIQUES

(30) Priorität: 18.05.2005 DE 102005022903
(43) Veröffentlichungstag der Anmeldung: 27.02.2008
(73) Patentinhaber: Merck Patent GmbH, 64293 Darmstadt (DE)
(72) Erfinder: Spreitzer, Hubert, 68519 Viernheim (DE); Heun, Susanne, 65812 Bad Soden (DE); Tallant, Neil Anthony, Whitefield Manchester M45 6TE (GB)
(86) Internationale Anmeldenummer: PCT/EP2006/004533
(87) Internationale Veröffentlichungsnummer: WO 2006/122732

(56) Entgegenhaltungen:
- CA-A1- 2 448 718
- US-A1- 2003 143 427
- SCURLOCK R D ET AL: "SINGLET OXYGEN AS A REACTIVE INTERMEDIATE IN THE PHOTODEGRADATION OF AN ELECTROLUMINESCENT POLYMER" JOURNAL OF THE AMERICAN CHEMICAL SOCIETY, AMERICAN CHEMICAL SOCIETY, WASHINGTON, DC, US, Bd. 117, Nr. 41, 18. Oktober 1995 (1995-10-18), Seiten 10194-10202, XP008061066 ISSN: 0002-7863
- RAHN M D ET AL: "PHOTOSTABILITY ENHANCEMENT OF PYRROMETHENE 567 AND PERYLENE ORANGE IN OXYGEN-FREE LIQUID AND SOLID DYE LASERS" APPLIED OPTICS, OSA, OPTICAL SOCIETY OF AMERICA, WASHINGTON, DC, US, Bd. 36, Nr. 24, 20. August 1997 (1997-08-20), Seiten 5862-5871, XP000699705 ISSN: 0003-6935

## Beschreibung

Die vorliegende Erfindung betrifft Lösungen organischer Halbleiter, sowie deren Verwendung in der Elektronikindustrie.

In einer Reihe verschiedenartiger Anwendungen, die im weitesten Sinne der Elektronikindustrie zugerechnet werden können, ist der Einsatz organischer Halbleiter als funktionelle Materialien seit geraumer Zeit Realität bzw. wird in naher Zukunft erwartet. Bei den organischen Elektrolumineszenzvorrichtungen (OLEDs) ist die Markteinführung bereits erfolgt, wie beispielsweise die Autoradios der Firma Pioneer oder eine Digitalkamera der Firma Kodak mit "organischem Display" belegen. Auch bei den polymeren lichtemittierenden Dioden (PLEDs) sind erste Produkte in Form einer kleinen Anzeige in einem Rasierapparat und einem Mobiltelefon der Firma Philips N. V. am Markt erhältlich. Der allgemeine Aufbau solcher PLEDs ist in WO 90/13148 wiedergegeben. Trotz aller Fortschritte sind noch deutliche Verbesserungen nötig, um diese Displays zu einer echten Konkurrenz zu den derzeit marktbeherrschenden Flüssigkristallanzeigen (LCD) zu machen bzw. diese zu überflügeln.

Eine Entwicklung, die sich seit einigen Jahren vor allem auf dem Gebiet der "Small molecule"-Displays abzeichnet, ist der Einsatz von Materialien, die aus dem Triplett-Zustand Licht emittieren können und somit Phosphoreszenz statt Fluoreszenz zeigen (M. A. Baldo et al., Appl. Phys. Lett. 1999, 75, 4-6), wodurch eine bis zu vierfache Energie- und Leistungseffizienz möglich ist. Als wesentliche Bedingungen für die praktische Anwendbarkeit sind hier insbesondere die effiziente Lichtemission und eine lange operative Lebensdauer zu nennen.

In letzter Zeit gibt es zunehmend Bemühungen, sich die Vorteile aufdampfbarer niedermolekularer Triplett-Emitter auch für aus Lösung verarbeitbare Anwendungen zu Nutze zu machen. So werden so genannte Hybrid-Device-Strukturen erwogen, die die Vorteile der "Small-molecule"-OLEDs mit denen der Polymer-OLEDs (= PLEDs) verbinden und durch Mischen eines niedermolekularen Triplett-Emitters in ein Polymer entstehen. Auch mehrere niedermolekulare Verbindungen können miteinander gemischt und aus Lösung verarbeitet werden. Weiterhin ist es möglich, den Triplett-Emitter in ein Polymer einzubauen und so ein Copolymer zu erzeugen. Dadurch wird die Gefahr der Phasenseparation bei Deviceherstellung und -betrieb vermieden. Diese Methoden haben den Vorteil, dass die Verbindungen aus Lösung verarbeitet werden können und dass kein teurer und aufwändiger Aufdampfprozess wie für Devices auf Basis niedermolekularer Verbindungen erforderlich ist. Das Aufbringen aus Lösung wird langfristig deutliche Vorteile gegenüber dem heute gängigen Vakuum-Verdampfungsprozess aufweisen, vor allem hinsichtlich Skalierbarkeit, Strukturierbarkeit, Beschichtungseffizienz und Ökonomie. Hier sind Druckverfahren die Möglichkeit der Wahl. Derzeit wird wegen der guten Steuerbarkeit, der erreichbaren hohen Auflösung und der großen Variabilität hauptsächlich an Tintenstrahl-Druckverfahren (InkJet Printing, IJP, z. B. EP 0880303) gearbeitet. Grundsätzlich eignen sich aber auch andere Druckverfahren, wie z. B. Offsetdruck, Siebdruck, Transferdruck oder Tiefdruck.

Insbesondere bei der Herstellung organischer Filme oder Pixel, die Triplett-Emitter enthalten, aus Lösung zeigen sich allerdings Probleme, die noch nicht zufriedenstellend gelöst sind und die bei der Verwendung fluoreszierender Polymere und Blends nicht oder nicht in dieser Form bekannt sind. So reagieren insbesondere Triplett-Emitter sehr empfindlich auf die Anwesenheit bestimmter Verbindungen in der Lösung, die die Lumineszenz der Emitter deutlich reduzieren oder ganz löschen können. Dieses Problem ist bei Verarbeitung von Triplett-Emittern durch Vakuum-Aufdampfprozesse unbekannt oder weniger bedeutend.

Sauerstofffreie, flüssige Zusammensetzungen, die einen organischen Halbleiter, der aus dem Triplett-Zustand Licht emittiert, und ein organisches Lösungsmittel enthalten, werden von R. D. Scurlock et al. ("Singlet Oxygen as a reactive intermediate in the photodegradation of an electroluminescent polymer", J. Am. Chem. Soc. 1995, 117, 10194-10202) sowie von M. D. Rahn et al. ("Photostability enhancement of pyrromethane 567 and perylene orange in oxygen-free liquid and solid dye laser", Applied Optics, Bd. 36, Nr. 24, 20.08.1997) beschrieben.

Flüssige Zusammensetzungen, enthaltend mindestens einen organischen Halbleiter, der aus dem Triplett-Zustand Licht emittiert, also Phosphoreszenz zeigt und der zur Bildung amorpher Filme befähigt ist, und mindestens ein organisches Lösungsmittel die einen Sauerstoffgehalt von weniger als 30 ppm aufweisen, werden in der JP 2002/170677 A offenbart.

Es ist daher Aufgabe der vorliegenden Erfindung, hierfür eine technische Verbesserung anzubieten. Überraschend wurde gefunden, dass Lösungen organischer Halbleiter, die aus dem Triplett-Zustand Licht emittieren, besonders gute Eigenschaften zeigen, wenn der Gehalt bestimmter Verbindungen und Verunreinigungen in diesen Lösungen einen bestimmten Grenzwert unterschreitet. Im Folgenden werden diese Verunreinigungen im Folgenden "Triplett-Quencher" genannt.

Gegenstand der Erfindung sind flüssige Zusammensetzungen, enthaltend mindestens einen organischen Halbleiter, der aus dem Triplett-Zustand Licht emittiert, also Phosphoreszenz zeigt, und der zur Bildung von amorphen Filmen befähigt ist, und mindestens ein organisches Lösemittel, die dadurch gekennzeichnet sind, dass als Triplett-Emitter Metallkomplexe verwendet werden, die bei Raumtemperatur in der Elektrolumineszenz aus dem Triplett-Zustand Licht emittieren und die mindestens ein Metall, ausgewählt aus Wolfram, Rhenium, Ruthenium, Osmium, Rhodium, Iridium, Palladium, Platin und Gold, enthalten und dass der Gehalt an Triplett-Quenchern in der Lösung kleiner als 10 ppm ist.

Die erfindungsgemäßen, flüssigen Zusammensetzungen können sowohl als Lösung als auch als Dispersion bzw. Emulsion vorliegen, wobei Lösungen bevorzugt sind. Bevorzugt liegt die flüssige Zusammensetzung als einphasiges System vor.

Als Lösungen im Sinne dieser Anmeldung werden flüssige, homogene Mischungen von Festsubstanzen in flüssigen Lösemitteln, in denen die Feststoffe molekulardispers gelöst vorliegen, d. h. die Mehrzahl der Feststoffmoleküle liegt tatsächlich gelöst und nicht in Form von Aggregaten bzw. Nano- oder Mikropartikeln vor, verstanden.

Unter organischen Lösemitteln im Sinne dieser Erfindung sollen organische Stoffe verstanden werden, die andere Stoffe auf physikalischem Wege zur Lösung bringen können, ohne dass sich beim Lösungsvorgang der lösende oder der gelöste Stoff chemisch verändern. Dabei kann entweder ein reines organisches Lösemittel oder eine Mischung mehrerer organischer Lösemittel verwendet werden. Bevorzugt beträgt die Löslichkeit des organischen Halbleiters im organischen Lösemittel bzw. in der Mischung organischer Lösemittel bei Raumtemperatur und Normaldruck (20°C und 1013 mbar) mindestens 1 g/l, besonders bevorzugt mindestens 3 g/l, ganz besonders bevorzugt mindestens 5 g/l, insbesondere mindestens 10 g/l unter Bildung einer optisch klaren fließfähigen Lösung.

Organische Halbleiter im Sinne dieser Anmeldung sind niedermolekulare, oligomere, dendritische oder polymere, organische oder metallorganische Verbindungen bzw. Mischungen von Verbindungen, die als Feststoff bzw. als Schicht halbleitende Eigenschaften aufweisen, d. h. bei denen die Energielücke zwischen Leitungs- und Valenzband zwischen 1,0 und 3,5 eV liegt.

Als organischer Halbleiter wird entweder eine Reinkomponente oder eine Mischung von zwei oder mehreren Komponenten, von denen mindestens eine halbleitende Eigenschaften aufweisen muss und aus dem Triplett-Zustand Licht emittiert, verwendet. Bevorzugt ist mindestens eine Komponente des organischen Halbleiters hochmolekular. Diese hochmolekulare Komponente, die oligomer, polymer oder dendritisch sein kann, hat ein Molekulargewicht M_{w} von größer 3000 g/mol, bevorzugt von größer 10000 g/mol, besonders bevorzugt von größer 50000 g/mol. Bei der Verwendung von Mischungen ist es nicht notwendig, dass jede der Komponenten halbleitende Eigenschaften aufweist. So können beispielsweise inerte niedermolekulare Verbindungen in Verbindung mit halbleitenden Polymeren verwendet werden. Ebenso können nichtleitende Polymere als inerte Matrix bzw. Binder zusammen mit einer oder mehreren niedermolekularen Verbindungen, die halbleitende Eigenschaften aufweisen, verwendet werden.

Unter Phosphoreszenz im Sinne dieser Erfindung wird eine durch äußere Energie, z. B. Licht oder elektrischen Strom, angeregte Lumineszenz verstanden, bei der die Emission durch einen Übergang aus einem Triplett-Zustand oder einem Mischzustand aus einem angeregten Singulett- und einem Triplett-Zustand in den Singulett-Grundzustand erzeugt wird. Dagegen wird unter Fluoreszenz eine durch äußere Energie angeregte Lumineszenz verstanden, bei der die Emission durch einen Übergang aus einem angeregten Singulett-Zustand in den Singulett-Grundzustand erzeugt wird. Diese beiden Prozesse lassen sich experimentell durch die Lebensdauern der angeregten Zustände unterscheiden, wobei die Lebensdauer des angeregten Singulett-Zustands in der Größenordnung von 10⁻¹⁰ bis 10⁻⁷ s und die des Triplett-Zustands in der Größenordnung von > 10⁻⁷ s liegt, was durch zeitaufgelöste Lumineszenz-Spektroskopie zu ermitteln ist.

Unter einem Triplett-Emitter im Sinne dieser Erfindung soll eine Verbindung, insbesondere ein Metallkomplex, verstanden werden, die bei Raumtemperatur in der Elektrolumineszenz aus dem Triplett-Zustand Licht emittiert, also Elektrophosphoreszenz statt Elektrofluoreszenz zeigt. Hierfür eignen sich erfindungsgemäß Metallkomplexe, die mindestens ein Metall enthalten, ausgewählt aus Wolfram, Rhenium, Ruthenium, Osmium, Rhodium, Iridium, Palladium, Platin und Gold, insbesondere Iridium und Platin. Im Sinne dieser Anmeldung werden alle Komplexe, die diese Metalle enthalten und Lumineszenz zeigen, als Triplett-Emitter bezeichnet.

Beispiele für Triplett-Emitter, die gut in organischen Lösemitteln löslich sind, können den Anmeldungen WO 02/081488, WO 04/026886 und DE 10345572.8 entnommen werden. Beispiele für Blends von Triplett-Emittern mit geeigneten Polymeren und Triplett-Copolymere können den Anmeldungen WO 04/070772, WO 04/113468, DE 10349033.7, DE 102004023278.4, DE 102004023277.6 und DE 102004032527.8 entnommen werden.

Triplett-Quencher im Sinne dieser Anmeldung sind Verbindungen, die den Triplett-Zustand des organischen Halbleiters löschen. Dies sind Verbindungen, deren Triplett-Niveau mindestens 0,05 eV tiefer liegt als das Triplett-Niveau des Triplett-Emitters. Entscheidend ist also die Lage des Triplett-Niveaus des Triplett-Quenchers relativ zum Triplett-Emitter. So ist es durchaus möglich, dass eine Verbindung, die für rote Triplett-Emission nicht stört, bei grüner Triplett-Emission zu vollständiger Löschung der Lumineszenz führt.

Unter der Triplett-Energie einer Verbindung wird die Energiedifferenz zwischen dem niedrigsten Triplettzustand T1 und dem Singulett-Grundzustand S0 verstanden.

Die Lage des Singulett-Grundzustands S0 wird bevorzugt mittels Cyclovoltammetrie durch Bestimmung des Oxidationspotenzials (Energielevel des HOMO) relativ zu einem bekannten Standard ermittelt. Die Energiedifferenz zwischen T1 und S0 wird bevorzugt spektroskopisch bestimmt, wie z. B. von D. Hertel et al. (J. Chem. Phys. 2001, 115, 10007) beschrieben. Die absolute Lage des Triplett-Niveaus bezüglich des Vakuumpotenzials E = 0 ergibt sich aus der Summe der Energie des Grundzustands S0 (Energielevel des HOMO) und der spektroskopisch bestimmten Energiedifferenz zwischen T1 und S0. Beispiele für experimentell bestimmte Triplett-Energien finden sich beispielsweise bei Turro (N. J. Turro, Modern Molecular Photochemistry, University Science Books, Sausalito/California, 1991).

Verbindungen mit einem niedrigen Triplett-Niveau sind beispielsweise Anthracen, Pyren, Naphthacen, Perylen oder auch molekularer Sauerstoff. Dies umfasst insbesondere auch Spurenverunreinigungen, die durch das Lösemittel eingeschleppt werden.

Es wurde gefunden, dass die Löschung der Lumineszenz deutlich verringert wird, wenn der Gehalt aller Triplett-Quencher in der flüssigen Zusammensetzung, insbesondere der Lösung, in Summe kleiner als 10 ppm ist. Bevorzugt ist der Gehalt kleiner als 1 ppm, besonders bevorzugt kleiner als 0,5 ppm, ganz besonders bevorzugt kleiner als 0,1 ppm, insbesondere kleiner als 0,01 ppm. Dagegen wurde beobachtet, dass bei einem Gehalt von mehr als etwa 10 ppm des Triplett-Quenchers eine deutliche Löschung der Lumineszenz auftritt. Dabei bedeuten ppm Gewichtsanteile.

Die erfindungsgemäßen, flüssigen Zusammensetzungen, insbesondere Lösungen, enthalten bevorzugt zwischen 0,01 und 20 Gew.-%, besonders bevorzugt zwischen 0,1 und 15 Gew.-%, ganz besonders bevorzugt zwischen 0,2 und 10 Gew.-%, insbesondere zwischen 0,25 und 5 Gew.-% des organischen Halbleiters.

Die Viskosität der erfindungsgemäßen, flüssigen Zusammensetzungen, insbesondere Lösungen, wird durch die Kombination von Lösemittel, Konzentration an gelöstem Halbleiter und dem Molekulargewicht der hochmolekularen Komponente bestimmt und ist im Rahmen dieser Erfindung nicht eingeschränkt. Für die verschiedenen oben genannten Druckverfahren erweisen sich aber gewisse Viskositätsbereiche als technisch notwendig. So ist z. B. für IJP ein Bereich von ca. 5 bis 15 mPas anzugeben, während für Siebdruck deutlich höhere Viskositäten erforderlich sein können (z. B. im Bereich von ca. 50 bis 200 mPas). Wird für großflächiges Beschichten Spin-Coating oder Rackeln verwendet, können Viskositäten im Bereich von ca. 10 bis 50 mPas in Frage kommen.

Geeignete Lösemittel für die erfindungsgemäßen, flüssigen Zusammensetzungen, insbesondere Lösungen, sind solche, wie sie auch für Lösungen fluoreszierender, organischer Halbleiter verwendet werden. Geeignete Beispiele können der Anmeldung WO 02/072714 entnommen werden. Weiterhin kann es sinnvoll sein, Lösemittel, in denen der organische Halbleiter gut löslich ist, und Lösemittel, in denen der organische Halbleiter schlecht löslich ist, miteinander zu kombinieren, wie beispielsweise in den nicht offen gelegten Anmeldungen DE 102004007777.0 und DE 102004023276.8 beschrieben.

Des Weiteren kann es auch sinnvoll sein, neben dem organischen Halbleiter bzw. Blend noch weitere Additive, wie z. B. in WO 03/019693 beschrieben, zuzusetzen.

Als bevorzugte Lösemittel bieten sich einfach oder mehrfach substituierte aromatische Lösemittel, insbesondere substituierte Benzole, Naphthaline, Biphenyle und Pyridine, an. Bevorzugte Substituenten sind Alkylgruppen, die auch fluoriert sein können, Halogenatome, bevorzugt Chlor und Fluor, Cyanogruppen, Alkoxygruppen, Dialkylaminogruppen, bevorzugt solche mit nicht mehr als 4 C-Atomen, oder auch Estergruppierungen. Besonders bevorzugte Substituenten sind Fluor, Chlor, Cyano, Methoxy, Ethoxy, Methyl, Trifluormethyl, Methylcarboxylat und/oder Ethylcarboxylat, wobei auch mehrere unterschiedliche Substituenten vorhanden sein können. Auch nicht-aromatische Lösemittel, wie beispielsweise Ameisensäurederivate, N-Alkyl-Pyrrolidone oder hochsiedende Ether, kommen als gute Lösemittel in Frage.

Die Verwendung Aldehyd-haltiger Lösemittel, nitrierter Aromaten und phosphorhaltiger Lösungsmittel (mangelnde Stabilität der Lösungen) und von Styrolderivaten bzw. anderen reaktiven Olefinen (Polymerisationsneigung der Lösemittel) hat sich als wenig vorteilhaft erwiesen.

Bevorzugt sind erfindungsgemäße, flüssige Zusammensetzungen, insbesondere Lösungen, enthaltend als Lösemittel mindestens ein Lösemittel ausgewählt aus 3-Fluor-benzotrifluorid, Benzotrifluorid, Dioxan, Trifluormethoxybenzol, 4-Fluor-benzotrifluorid, 3-Fluorpyridin, Toluol, 2-Fluortoluol, 2-Fluor-benzotrifluorid, 3-Fluortoluol, Pyridin, 4-Fluortoluol, 2,5-Difluortoluol, 1-Chlor-2,4-difluorbenzol, 2-Fluorpyridin, 3-Chlorfluorbenzol, 1-Chlor-2,5-difluorbenzol, 4-Chlorfluorbenzol, Chlorbenzol, 2-Chlorfluorbenzol, p-Xylol, m-Xylol, o-Xylol, 2,6-Lutidin, 2-Fluor-m-xylol, 3-Fluor-o-xylol, 2-Chlorbenzotrifluorid, Dimethylformamid, 2-Chlor-6-fluortoluol, 2-Fluoranisol, Anisol, 2,3-Dimethylpyrazin, Brombenzol, 4-Fluoranisol, 3-Fluoranisol, 3-Trifluormethylanisol, 2-Methylanisol, Phenetol, Benzodioxol, 4-Methylanisol, 3-Methylanisol, 4-Fluor-3-methylanisol, 1,2-Dichlorbenzol, 2-Fluorbenzonitril, 4-Fluorveratrol, 2,6-Dimethylanisol, Anilin, 3-Fluorbenzonitril, 2,5-Dimethylanisol, 2,4-Dimethylanisol, Benzonitril, 3,5-Dimethylanisol, N,N-Dimethylanilin, 1-Fluor-3,5-dimethoxybenzol, Phenylacetat, N-Methylanilin, Methylbenzoat, N-Methylpyrrolidon, 3,4-Dimethylanisol, o-Tolunitril, Veratrol, Ethylbenzoat, N,N-Diethylanilin, Propylbenzoat, 1-Methylnaphthalin, Butylbenzoat, 2-Methylbiphenyl, 2-Phenyl-pyridin oder 2,2'-Bitolyl.

Es ist bevorzugt, wenn die Siedepunkte aller verwendeten Lösemittel größer als 80°C sind, besonders bevorzugt größer als 100°C. Weiterhin bevorzugt sind die Siedepunkte aller verwendeten Lösemittel kleiner als 300°C, besonders bevorzugt kleiner oder gleich 270°C, ganz besonders bevorzugt kleiner oder gleich 250°C. Bei höher siedenden Lösemitteln ist das restliche Lösemittel nach Filmbildung nur schwierig und unter hohem technischen Aufwand vollständig zu entfernen. Siedepunkt bezieht sich auf den Siedepunkt unter Normaldruck (1013 mbar).

Der Schmelzpunkt aller verwendeten Lösemittel ist bevorzugt kleiner oder gleich 15°C. Dies ist sinnvoll, da die Lösungen unter Umständen zwischen Herstellung und Einsatz über Tage bis zu Monaten gelagert bzw. eventuell auch transportiert werden müssen. Hier muss sichergestellt werden, dass die Lösungen auch als solche stabil bleiben und nicht bei Lagerung, Transport und/oder kleineren Temperaturschwankungen ausfrieren oder sonstige nachteiligen Lager- und/oder Transportschäden erleiden.

In einer bevorzugten Ausführungsform der Erfindung enthält das Lösemittel bzw. Lösemittelgemisch, das zur Bereitung der erfindungsgemäßen, flüssigen Zusammensetzungen, insbesondere Lösungen, verwendet wird, weniger als 10 ppm Triplett-Quencher, besonders bevorzugt weniger als 5 ppm.

Zum Herstellen der flüssigen Zusammensetzungen, insbesondere Lösungen, wird der organische Halbleiter bzw. Blend in der gewünschten Konzentration in dem gewünschen Lösemittel bzw. Lösemittelgemisch gelöst. Es kann sinnvoll sein, den Lösevorgang beispielsweise durch Erhitzen, Schütteln und/oder Rühren zu beschleunigen. Aggregate des organischen Halbleiters können dabei auch durch äußere mechanische Einwirkung, zum Beispiel durch Ultraschall wie in WO 03/019694 beschrieben, zerkleinert werden. Es hat sich weiterhin als sinnvoll erwiesen, vor Anwendung der Lösungen diese zu filtrieren, um sie beispielsweise von kleineren Mengen vernetzter Bestandteile oder von Staubpartikeln zu reinigen.

Um die Anwesenheit von Triplett-Quenchern zu reduzieren, ist es sinnvoll, zunächst den organischen Halbleiter so zu reinigen, dass dieser im Feststoff keine Triplett-Quencher mehr in erheblicher Menge enthält. Hier ist es sinnvoll, den Gehalt an diesen Triplett-Quenchern bis unter die Nachweisgrenze (z. B. für GC-MS, HPLC-MS) zu verringern. Praktisch bedeutet dies auf jeden Fall Mengen kleiner 100 ppm, bevorzugt kleiner 10 ppm, besonders bevorzugt kleiner 1 ppm, ganz besonders bevorzugt kleiner 0,1 ppm. Dies kann beispielsweise durch wiederholte Umkristallisation, durch wiederholtes Umfällen, durch Extraktionsverfahren, durch chromatographische Methoden oder durch andere gebräuchliche Reinigungsmethoden der organischen Chemie erfolgen. Der Gehalt der Triplett-Quencher in der Lösung kann durch allgemein gebräuchliche analytische Methoden erfolgen, insbesondere durch GC-MS oder durch HPLC-MS. Der Prozess ist abgeschlossen, wenn ein weiterer Reinigungsschritt zu keiner Verbesserung der Device-Performance mehr führt.

Für die Herstellung der flüssigen Zusammensetzungen, insbesondere Lösungen, ist die Verwendung hochreiner Lösemittel sinnvoll, deren Gehalt an Triplett-Quenchern unter der oben genannten Grenze liegt.

Ein weiterer Gegenstand der Erfindung ist ein Verfahren zur Herstellung der erfindungsgemäßen, flüssigen Zusammensetzungen, insbesondere Lösungen. Da insbesondere auch der Gehalt an bestimmten Gasen, vor allem Sauerstoff (welches durch seinen Triplett-Grundzustand ein extrem starker Triplett-Quencher ist), in der flüssigen Zusammensetzung, insbesondere Lösung, stören kann, ist es sinnvoll, die flüssige Zusammensetzung, insbesondere Lösung, unter einer inerten Atmosphäre, wie z. B. Stickstoff, Argon oder Helium, unter Verwendung entgaster Lösemittel zu bereiten und/oder nach Bereitung der Lösung zu entgasen. Um den Gehalt von Sauerstoff unter die oben genannte Grenze abzusenken, wird die flüssige Zusammensetzung, insbesondere Lösung, bevorzugt mindestens 15 Minuten durch Durchleiten des Schutzgases durch die Lösung entgast, besonders bevorzugt mindestens 30 Minuten, insbesondere mindestens 60 Minuten. Der Gehalt an Sauerstoff in der flüssigen Zusammensetzung, insbesondere Lösung, lässt sich durch eine Sauerstoff-Sonde bestimmen, beispielsweise durch entsprechende Sonden von Mettler-Toledo (siehe auch Beispiel 1).

Ein weiterer Erfindungsgegenstand ist die Verwendung der erfindungsgemäßen, flüssigen Zusammensetzungen, insbesondere Lösungen, um Schichten des organischen Halbleiters auf einem Substrat zu erzeugen.

Eine bevorzugte Ausführungsform ist dabei die Verwendung von Druckverfahren. Besonders bevorzugt ist die Verwendung von Tintenstrahl-Druckverfahren (IJP).

Die erfindungsgemäßen, flüssigen Zusammensetzungen, insbesondere Lösungen, organischer Halbleiter, die aus dem Triplett-Zustand Licht emittieren, eignen sich im Gegensatz zu Lösungen gemäß dem Stand der Technik deutlich besser für die Herstellung organischer, elektronischer Vorrichtungen, da die Lumineszenz der aus diesen Filmen gebildeten Schichten nicht oder deutlich weniger stark gelöscht wird und diese daher eine deutlich effizientere Elektrolumineszenz zeigen.

Im vorliegenden Anmeldetext und auch in den im Weiteren folgenden Beispielen wird vor allem auf erfindungsgemäße, flüssige Zusammensetzungen, insbesondere Lösungen, zur Herstellung organischer und polymerer Leuchtdioden und die entsprechenden Displays abgezielt. Trotz dieser Beschränkung der Beschreibung ist es für den Fachmann ohne weiteres erfinderisches Zutun möglich, entsprechende erfindungsgemäße, flüssige Zusammensetzungen, insbesondere Lösungen, auch für die Herstellung anderer Devices anzuwenden, z. B. für organische Solarzellen (O-SCs) oder organische Laserdioden (O-Laser).

Die vorliegende Erfindung wird durch die folgenden Beispiele näher erläutert, ohne sie darauf einschränken zu wollen. Der Fachmann kann aus der Beschreibung und den aufgeführten Beispielen ohne erfinderisches Zutun weitere erfindungsgemäße, flüssige Zusammensetzungen, insbesondere Lösungen, bereiten und diese anwenden, um daraus Schichten zu erzeugen.

### Beispiele

### Beispiel 1: Sensitivität einer Lösung gegen Sauerstoff

Es wird eine Lösung des Polymers TP-009 in Toluol bereitet. Das Polymer TP-009 ist ein aus dem Triplettzustand rot emittierendes Polymer (λₘₐₓ = 627 nm; CIE-Koordinaten ca. 0,67 / 0,32), welches eine Zusammensetzung wie das Material **P6** in der Anmeldung DE 102004032527.8 besitzt. Der hier verwendete Batch (POLY-2140) hat ein Mw von 560 kDalton, ein Mp von 190 kDalton ein Mn von 90 kDalton, und eine Lösung von 14 g/l in Anisol zeigt bei 20°C eine Viskosität von 7,0 mPas (gemessen bei einer Scherrate von 40 s⁻¹). Das verwendete Toluol wird von MERCK bezogen und hat die Bestellnummer #108325.

Es werden vier verschiedene Lösungen mit jeweils 100 ml Lösung hergestellt. Dabei werden 1,2 g Polymer auf 100 ml Lösemittel gegeben und bei 60°C für 10 Stunden gerührt. Das Rühren wird in allen Fällen unter Schutzgas (Argon, 99,999999%ig) durchgeführt, allerdings werden die Lösungen vor Verwendung unterschiedlich behandelt. In allen Fällen wird der Sauerstoffgehalt im Toluol mit einer modifizierten InPro6800 (Mettler-Toledo) Sauerstoffsonde vermessen.

Lösung 1: wird ohne weitere Behandlung zur PLED-Device-Fertigung verwendet. Es wird ein Sauerstoffgehalt von 68 ppm detektiert.

Lösung 2: hier wird vor der Weiterbehandlung für 5 Minuten unter Rühren ein kräftiger Argonstrom (ca. 1-2 Blasen pro Sekunde) durch die Lösung geleitet. Es wird ein Sauerstoffgehalt von 12 ppm detektiert.

Lösung 3: analog zu Lösung 2, nur wird hierfür 15 Minuten Argon eingeleitet. Es wird ein Sauerstoffgehalt von 1,5 ppm detektiert.

Lösung 4: analog zu Lösung 2 und 3, nur wird hier für 30 Minuten Argon eingeleitet. Sauerstoff ist hier nicht mehr detektierbar. In dem verwendeten Medium (Toluol) haben Vergleichsmessungen eine Nachweisgrenze von ca. 0,1 bis 0,2 ppm Sauerstoff ergeben.

Aus den vier Lösungen werden - wie in WO 04/037887 beschrieben - Testdevices gebaut. Die Device-Fertigung verläuft hierbei zunächst an Luft (ITO-Reinigung, PEDOT-Spincoaten), die Fertigungsschritte bzgl. LEP-Spincoaten (LEP steht hier und im Folgenden für "licht-emittierendes Polymer") werden in einer Glovebox durchgeführt (Restsauerstoffgehalt < 0,1 ppm), das anschließende Aufdampfen der Kathode und das Versiegeln der Device erfolgt jeweils unter Ausschluss von Luft. Der Schichtaufbau ist dabei jeweils ITO, 80 nm PEDOT, 80 nm LEP, ca. 3 nm Ba, 150 nm Ag. Die Testdioden haben eine Größe von ca. 3 x 3 mm².

Diese Testdioden werden auf ihre Anwendungseigenschaften (Startwerte: IVL-Kurven) und die damit erzielbaren, operativen Lebensdauern (Absinken der Helligkeit auf 50 % der Anfangshelligkeit) untersucht.

Die wichtigsten Ergebnisse sind in Tabelle 1 zusammengefasst:

**Tabelle 1 Deviceergebnisse für POLY-2140 aus Lösungen 1 bis 4.**

| | **Max. Effizienz [Cd/A]** | **Spannung für 800 Cd/m2 [V]** | **Spannung für 5000 Cd/m2 [V]** | **Lebensdauer LT-50 bei 800 Cd/m2 Anfangshelligkeit [h]** |
|---|---|---|---|---|
| Lösung 1 | 6,5 | 5,8 | 9,2 | 220 |
| Lösung 2 | 8,4 | 5,3 | 7,9 | 270 |
| Lösung 3 | 8,7 | 5,2 | 7,6 | 320 |
| Lösung 4 | 8,7 | 5,1 | 7,5 | 330 |

Aus den Ergebnissen ist zu erkennen, dass ein Sauerstoffgehalt von 12 ppm starke und von 68 ppm sehr starke Auswirkungen auf die Device-Performance zeigt. Es sind auch noch geringe Unterschiede bei den Lösungen 3 und 4 zu erkennen, allerdings sind diese im Bereich der Mess- und Device-Präparations-Schwankung.

Um zu erkennen, ob der oben gezeigte starke Effekt tatsächlich vor allem bei Triplett-Emittern eine Rolle spielt, wird ein analoges Experiment mit einem aus dem Singulettzustand emittierenden Polymer durchgeführt.

Es wird eine Lösung des Polymers POLY1 in Toluol bereitet. Das Polymer POLY1 ist ein aus dem Singulettzustand gelb emittierendes Polymer (CIE-Koordinaten ca. 0,51 / 0,49), welches eine Zusammensetzung wie das Material POLY1 in der Anmeldung DE 102004023276.8 besitzt. Der hier verwendete Batch (PY-46) hat ein Mw von 1600 kDalton, ein Mp von 1150 kDalton, ein Mn von 310 kDalton, und eine Lösung von 5 g/l in Toluol zeigt bei 20°C eine Viskosität von 55,8 mPas (gemessen bei einer Scherrate von 40 s⁻¹). Toluol wird wie oben verwendet.

Es werden vier verschiedene Lösungen mit jeweils 100 ml Lösung hergestellt. Dabei werden 0,45 g Polymer auf 100 ml Lösemittel gegeben und bei 60°C für 24 Stunden gerührt. Das Rühren wird in allen Fällen unter Schutzgas (Argon, 99,999999%ig) durchgeführt, allerdings werden die Lösungen vor Verwendung unterschiedlich behandelt. In allen Fällen wird der Sauerstoffgehalt im Toluol mit einer modifizierten InPro6800 (Mettler-Toledo) Sauerstoffsonde vermessen.

Lösung 5: wird ohne weitere Behandlung zur PLED-Device-Fertigung verwendet. Es wird ein Sauerstoffgehalt von 33 ppm detektiert.

Lösung 6: hier wird vor der Weiterbehandlung für 5 Minuten unter Rühren ein kräftiger Argonstrom (ca. 1-2 Blasen pro Sekunde) durch die Lösung geleitet. Es wird ein Sauerstoffgehalt von 10 ppm detektiert.

Lösung 7: analog zu Lösung 6, nur wird hierfür 15 Minuten Argon eingeleitet. Es wird ein Sauerstoffgehalt von 0,9 ppm detektiert.

Lösung 8: analog zu Lösung 6 und 7, nur wird hier für 30 Minuten Argon eingeleitet. Sauerstoff ist hier nicht mehr detektierbar. Wie oben beschrieben, liegt die Nachweisgrenze bei ca. 0,1 bis 0,2 ppm Sauerstoff.

Es werden - wie oben beschreiben - analoge Testdioden präpariert.

Diese Testdioden werden auf ihre Anwendungseigenschaften (Startwerte: IVL-Kurven) und die damit erzielbaren operativen Lebensdauern untersucht.

Die wichtigsten Ergebnisse sind in Tabelle 2 zusammengefasst:

**Tabelle 2 Deviceergebnisse für PY-46 aus Lösungen 5 bis 8.**

| | **Max. Effizienz [Cd/A]** | **Spannung für 800 Cd/m2 [V]** | **Spannung für 5000 Cd/m2 [V]** | **Lebensdauer LT-50 bei 5000 Cd/m2 Anfangshelligkeit [h]** |
|---|---|---|---|---|
| Lösung 5 | 11,8 | 3,6 | 4,9 | 980 |
| Lösung 6 | 12,1 | 3,4 | 4,8 | 1030 |
| Lösung 7 | 12,3 | 3,3 | 4,7 | 1080 |
| Lösung 8 | 12,2 | 3,4 | 4,75 | 1050 |

Aus diesen Ergebnissen ist erkennbar, dass Lösung 5 eine schwache Abweichung zeigt, die allerdings am Rande der Messungenauigkeit liegt. Die Lösungen 6 bis 8 liefern im Rahmen der Messgenauigkeit identische Ergebnisse.

Dies zeigt allerdings klar, dass die Sauerstoffsensitivität bei Lösungen enthaltend Triplett-Emitter deutlich stärker ist als jene von Singulett-Emittern.

### Beispiel 2: Sensitivität einer Lösung gegenüber 9-Methylanthracen

Im Rahmen einer Entwicklung eines optimierten Lösungsgemisches für die Anwendung beim IJP werden Lösungen des in Beispiel 1 beschriebenen POLY-2140 in unterschiedlichen Mischungen, welche alle 1-Methylnaphthalin enthalten, hergestellt und untersucht. Dabei wird im Laufe der Zeit erkannt, dass die Device-Ergebnisse relativ starken Schwankungen unterworfen sind, die zunächst nicht erklärt werden können. Um diesen Schwankungen auf die Spur zu kommen, werden die verwendeten Lösemittel (u. a. auch Anisol, 4-Methylanisol und das genannte 1-Methylnaphthalin) genauer untersucht, zunächst via GC und dann via GC-MS. Dabei wird schließlich gefunden, dass in 1-Methylnaphthalin je nach Charge geringe Mengen einer Verunreinigung enthalten sind, welche ein Molekulargewicht von ca. 192 g/mol aufweist. Eine genauere Zuordnung ist aufgrund der geringen Substanzmengen nicht möglich (es werden je nach 1-Methylnaphthalin-Charge zwischen 0 ppm, d. h. nicht nachgewiesen, und 35 ppm der entsprechenden Verbindung gefunden). Durch intensives Reinigen (mehrfache fraktionierte Destillation) kann die Verunreinigung in allen Fällen auf einen Gehalt unterhalb der Nachweisgrenze gesenkt werden. Werden diese Lösemittel dann verwendet, können die oben genannten Schwankungen vermieden werden.

Um das geschilderte Phänomen zu klären, wird folgendes Experiment durchgeführt:
Es werden vier Lösungen des oben bereits genannten POLY-2140 in reinem 1-Methylnaphthalin bereitet. Dabei wird das oben genannte "hochgereinigte" 1-Methylnaphthalin verwendet. Die Lösungsbereitung geschieht analog zu Beispiel 1, nur dass hier jeweils nur 0,80 g Polymer in 100 ml Lösemittel gelöst werden. Alle vier Lösungen werden auch jeweils für 30 Minuten mit Argon begast. Der jeweilige Sauerstoffgehalt ist anschließend unterhalb der Nachweisgrenze.

Die Lösungen werden allerdings mit geringen Mengen eines potenziellen Störstoffes (Triplett-Quencher) versetzt, der ähnliche Eigenschaften wie die o. g. Verunreinigung aufweisen könnte: 9-Methylanthracen (C₁₅H₁₂, M = 192.26 g/mol).
Lösung 9: 0,00 mg 9-Methylanthracen (0 ppm).
Lösung 10: 0,15 mg 9-Methylanthracen (ca. 1,5 ppm).
Lösung 11: 1,2 mg 9-Methylanthracen (ca. 12 ppm).
Lösung 12: 6,8 mg 9-Methylanthracen (ca. 68 ppm).

Es werden - wie in Beispiel 1 beschrieben - analoge Testdioden präpariert. Ein Unterschied ist hier jedoch anzumerken: Da 1-Methylnaphthalin einen sehr hohen Siedepunkt (243 °C) besitzt, wird hier während des LEP-Spincoaten gleichzeitig mit einer NIR-Wärmequelle das Substrat bestrahlt (siehe WO 03/038923), um homogene Filme zu erzeugen. Trotzdem werden -wie mit diesem Lösemittel immer- etwas schlechtere Device-Eigenschaften gefunden, was vermutlich auf etwas schlechtere Filmbildung durch Spin-Coaten aus diesem hochsiedenden Lösemittel zurückgeführt werden kann.

Diese Testdioden werden auf ihre Anwendungseigenschaften (Startwerte: IVL-Kurven) und die damit erzielbaren operativen Lebensdauern untersucht.

Die wichtigsten Ergebnisse sind in Tabelle 3 zusammengefasst:

**Tabelle 3 Deviceergebnisse für POLY-2140 aus Lösungen 9 bis 12.**

| | **Max. Effizienz [Cd/A]** | **Spannung für 800 Cd/m2 [V]** | **Spannung für 5000 Cd/m2 [V]** | **Lebensdauer LT-50 bei 800 Cd/m2 Anfangshelligkeit [h]** |
|---|---|---|---|---|
| Lösung 9 | 7,6 | 6,3 | 10,1 | 300 |
| Lösung 10 | 7,5 | 6,2 | 10,0 | 300 |
| Lösung 11 | 7,0 | 6,2 | 10,1 | 280 |
| Lösung 12 | 5,1 | 6,6 | 10,8 | 240 |

Aus den Ergebnissen ist zu erkennen, dass die Lösungen 9 und 10 nahezu identische Device-Ergebnisse liefern, während die Lösung 11 etwas, die Lösung 12 stark in ihren Eigenschaften abfällt. Somit ist klar erkennbar, dass ein Material wie das verwendete 9-Methylanthracen drastische Auswirkungen auf die Deviceeigenschaften besitzt, so es in einem Gehalt im Bereich von 10 ppm oder mehr in entsprechenden Lösungen enthalten ist.

Da 9-Methylanthracen eine Triplettenergie von ca. 1,82 eV und eine HOMO-Lage von ca. 5,8 - 5,6 eV besitzt, ergibt sich aus der Differenz ein Triplett-Niveau von ca. 4,0 - 3,8 eV (vs. Vakuum). Das Polymer TP-009 besitzt eine Triplettenergie von ca. 2,0 - 1,9 eV und eine HOMO-Lage von ca. 5,2 eV. Daraus ergibt sich ein Triplett-Niveau von ca. 3,2 - 3,3 eV (vs. Vakuum). Man sieht also, dass das Triplett-Niveau von 9-Methylanthracen tiefer liegt als das des Polymers TP-009. Dies legt die Vermutung nahe, dass 9-Methylanthracen Triplettexcitonen "abfängt" und die dann erhaltene Energie nicht-strahlend abgibt. Das Lösemittel selbst ist hier nicht störend, die Triplettenergie ist im Bereich von ca. 2,7 eV.

Um diese Vermutung zu unterstützen, wird ein Vergleichsbeispiel durchgeführt:
Wie in Beispiel 1 werden die analogen Lösungen 13 bis 16 enthaltend das fluoreszierende Polymer PY-46 in 1-Methylnaphthalin präpariert. Hierbei werden jeweils 0,4 g Polymer in 100 ml Lösemittel analog zu den Angaben in Beispiel 1 und den oben in Beispiel 2 beschriebenen Maßnahmen (Entgasen, hochgereinigtes Lösemittel) gelöst.

Die Lösungen werden dann, ebenfalls in Analogie zu dem oben beschriebenen, mit unterschiedlichen Mengen 9-Methylanthracen versetzt:
Lösung 13: 0,00 mg 9-Methylanthracen (0 ppm).
Lösung 14: 0,18 mg 9-Methylanthracen (ca. 1,8 ppm).
Lösung 15: 1,6 mg 9-Methylanthracen (ca. 16 ppm).
Lösung 16: 6,0 mg 9-Methylanthracen (ca. 60 ppm).

Die Lösungen werden analog den obigen durch Präparation von Testdioden untersucht. Die Ergebnisse sind in Tabelle 4 zusammengefasst:

**Tabelle 4 Deviceergebnisse für PY-46 aus Lösungen 13 bis 16.**

| | **Max. Effizienz [Cd/A]** | **Spannung für 800 Cd/m2 [V]** | **Spannung für 5000 Cd/m2 [V]** | **Lebensdauer LT-50 bei 800 Cd/m2 Anfangshelligkeit [h]** |
|---|---|---|---|---|
| Lösung 13 | 10,2 | 3,5 | 5,1 | 950 |
| Lösung 14 | 10,3 | 3,6 | 5,1 | 930 |
| Lösung 15 | 10,1 | 3,5 | 5,2 | 960 |
| Lösung 16 | 10,3 | 3,6 | 5,1 | 940 |

Aus diesen Ergebnissen ist unschwer zu erkennen, dass 9-Methylanthracen keinen Einfluss auf die Device-Eigenschaften des fluoreszierenden Polymers hat.

Es lässt sich also der Schluss ziehen, dass 9-Methylanthracen tatsächlich als Triplett-Quencher fungiert und selektiv Triplett-emittierende Materialien stört.

## Patentansprüche

1. Flüssige Zusammensetzungen, enthaltend mindestens einen organischen Halbleiter, der aus dem Triplett-Zustand Licht emittiert, also Phosphoreszenz zeigt, und der zur Bildung von amorphen Filmen befähigt ist, und mindestens ein organisches Lösemittel, **dadurch gekennzeichnet, dass** als Triplett-Emitter Metallkomplexe verwendet werden, die bei Raumtemperatur in der Elektrolumineszenz aus dem Triplett-Zustand Licht emittieren und die mindestens ein Metall, ausgewählt aus Wolfram, Rhenium, Ruthenium, Osmium, Rhodium, Iridium, Palladium, Platin und Gold, enthalten und dass der Gehalt an Triplett-Quenchern in der Lösung kleiner als 10 ppm ist.

2. Zusammensetzungen gemäß Anspruch 1, **dadurch gekennzeichnet, dass** diese als Lösung, Dispersion oder Emulsion vorliegen.

3. Zusammensetzungen gemäß Anspruch 2, **dadurch gekennzeichnet, dass** die Zusammensetzung als einphasiges System vorliegt.

4. Zusammensetzungen gemäß einem oder mehreren der Ansprüche 1 bis 3, **dadurch gekennzeichnet, dass** die Löslichkeit des organischen Halbleiters im organischen Lösemittel bzw. in der Mischung organischer Lösemittel bei Raumtemperatur und Normaldruck mindestens 1 g/l beträgt.

5. Zusammensetzungen gemäß einem oder mehreren der Ansprüche 1 bis 4, **dadurch gekennzeichnet, dass** mindestens eine Komponente des organischen Halbleiters hochmolekular ist.

6. Zusammensetzungen gemäß einem oder mehreren der Ansprüche 1 bis 5, **dadurch gekennzeichnet, dass** das Triplett-Niveau des Triplett-Quenchers mindestens 0,05 eV tiefer liegt als das Triplett-Niveau des Triplett-Emitters.

7. Zusammensetzungen gemäß einem oder mehreren der Ansprüche 1 bis 6, **dadurch gekennzeichnet, dass** der Triplett-Quencher molekularer Sauerstoff ist.

8. Zusammensetzungen gemäß einem oder mehreren der Ansprüche 1 bis 7, **dadurch gekennzeichnet, dass** der Gehalt des Triplett-Quenchers kleiner als 1 ppm ist.

9. Zusammensetzungen gemäß einem oder mehreren der Ansprüche 1 bis 8, **dadurch gekennzeichnet, dass** diese zwischen 0,01 und 20 Gew.-% des organischen Halbleiters enthalten.

10. Zusammensetzungen gemäß einem oder mehreren der Ansprüche 1 bis 9, **dadurch gekennzeichnet, dass** die Lösemittel ausgewählt sind aus der Gruppe der einfach oder mehrfach substituierten aromatischen Lösemittel, insbesondere substituierte Benzole, Naphthaline, Biphenyle und Pyridine, bevorzugt substituiert mit Alkylgruppen, die auch fluoriert sein können, Halogenatomen, Cyanogruppen, Alkoxygruppen, Dialkylaminogruppen oder Estergruppierungen, oder der nicht-aromatischen Lösemittel, ausgewählt aus Ameisensäurederivaten, N-Alkyl-Pyrrolidonen oder hochsiedenden Ethern.

11. Zusammensetzungen gemäß Anspruch 10, **dadurch gekennzeichnet, dass** mindestens ein Lösemittel ausgewählt ist aus der Gruppe bestehend aus 3-Fluor-benzotrifluorid, Benzotrifluorid, Dioxan, Trifluormethoxybenzol, 4-Fluor-benzotrifluorid, 3-Fluorpyridin, Toluol, 2-Fluortoluol, 2-Fluor-benzotrifluorid, 3-Fluortoluol, Pyridin, 4-Fluortoluol, 2,5-Difluortoluol, 1-Chlor-2,4-difluorbenzol, 2-Fluorpyridin, 3-Chlorfluorbenzol, 1-Chlor-2,5-difluorbenzol, 4-Chlorfluorbenzol, Chlorbenzol, 2-Chlorfluorbenzol, p-Xylol, m-Xylol, o-Xylol, 2,6-Lutidin, 2-Fluor-m-xylol, 3-Fluor-o-xylol, 2-Chlorbenzotrifluorid, Dimethylformamid, 2-Chlor-6-fluortoluol, 2-Fluoranisol, Anisol, 2,3-Dimethylpyrazin, Brombenzol, 4-Fluoranisol, 3-Fluoranisol, 3-Trifluormethylanisol, 2-Methylanisol, Phenetol, Benzodioxol, 4-Methylanisol, 3-Methylanisol, 4-Fluor-3-methyl-anisol, 1,2-Dichlorbenzol, 2-Fluorbenzonitril, 4-Fluorveratrol, 2,6-Dimethylanisol, Anilin, 3-Fluorbenzonitril, 2,5-Dimethylanisol, 2,4-Dimethylanisol, Benzonitril, 3,5-Dimethylanisol, N,N-Dimethylanilin, 1-Fluor-3,5-dimethoxybenzol, Phenylacetat, N-Methylanilin, Methylbenzoat, N-Methylpyrrolidon, 3,4-Dimethylanisol, o-Tolunitril, Veratrol, Ethylbenzoat, N,N-Diethylanilin, Propylbenzoat, 1-Methylnaphthalin, Butylbenzoat, 2-Methylbiphenyl, 2-Phenyl-pyridin oder 2,2'-Bitolyl.

12. Zusammensetzungen gemäß einem oder mehreren der Ansprüche 1 bis 11, **dadurch gekennzeichnet, dass** die Siedepunkte aller verwendeten Lösemittel größer als 80°C sind.

13. Zusammensetzungen gemäß einem oder mehreren der Ansprüche 1 bis 12, **dadurch gekennzeichnet, dass** das oder die verwendeten Lösemittel weniger als 10 ppm Triplett-Quencher enthalten.

14. Verfahren zur Herstellung von Zusammensetzungen gemäß einem oder mehreren der Ansprüche 1 bis 13, **dadurch gekennzeichnet, dass** sie unter einer inerten Atmosphäre hergestellt werden und/oder unter Verwendung entgaster Lösemittel hergestellt werden und/oder dass die Zusammensetzungen nach Herstellung entgast werden.

15. Verfahren zur Herstellung von Zusammensetzungen gemäß Anspruch 14, **dadurch gekennzeichnet, dass** die Zusammensetzung mindestens 15 Minuten durch Durchleiten eines inerten Gases durch die flüssige Zusammensetzung entgast wird.

16. Verwendung von Zusammensetzungen gemäß einem oder mehreren der Ansprüche 1 bis 13 zur Erzeugung von Schichten des organischen Halbleiters auf einem Substrat.

17. Verwendung von Zusammensetzungen gemäß einem oder mehreren der Ansprüche 1 bis 13 zur Herstellung organischer elektronischer Vorrichtungen, insbesondere organischer oder polymerer Leuchtdioden, organischer Solarzellen und organischer Laserdioden.

18. Verwendung von Zusammensetzungen gemäß Anspruch 16 und/oder 17 in einem Druckverfahren.

19. Verwendung gemäß Anspruch 18, **dadurch gekennzeichnet, dass** es sich um ein Tintenstrahl-Druckverfahren handelt.

## Claims

1. Liquid compositions comprising at least one organic semiconductor which emits light from the triplet state, i.e. exhibits phosphorescence, and which is capable of the formation of amorphous films, and at least one organic solvent, **characterised in that** the triplet emitters used are metal complexes which emit light from the triplet state at room temperature in electroluminescence and which contain at least one metal selected from tungsten, rhenium, ruthenium, osmium, rhodium, iridium, palladium, platinum and gold and **in that** the content of triplet quenchers in the solution is less than 10 ppm.

2. Compositions according to Claim 1, **characterised in that** they are in the form of a solution, dispersion or emulsion.

3. Compositions according to Claim 2, **characterised in that** the composition is in the form of a single-phase system.

4. Compositions according to one or more of Claims 1 to 3, **characterised in that** the solubility of the organic semiconductor in the organic solvent or in the mixture of organic solvents at room temperature and atmospheric pressure is at least 1 g/l.

5. Compositions according to one or more of Claims 1 to 4, **characterised in that** at least one component of the organic semiconductor has a high molecular weight.

6. Compositions according to one or more of Claims 1 to 5, **characterised in that** the triplet level of the triplet quencher is at least 0.05 eV lower than the triplet level of the triplet emitter.

7. Compositions according to one or more of Claims 1 to 6, **characterised in that** the triplet quencher is molecular oxygen.

8. Compositions according to one or more of Claims 1 to 7, **characterised in that** the content of the triplet quencher is less than 1 ppm.

9. Compositions according to one or more of Claims 1 to 8, **characterised in that** they comprise between 0.01 and 20% by weight of the organic semiconductor.

10. Compositions according to one or more of Claims 1 to 9, **characterised in that** the solvents are selected from the group of mono- or polysubstituted aromatic solvents, in particular substituted benzenes, naphthalenes, biphenyls and pyridines, preferably substituted by alkyl groups, which may also be fluorinated, halogen atoms, cyano groups, alkoxy groups, dialkylamino groups or ester groups, or nonaromatic solvents selected from formic acid derivatives, N-alkylpyrrolidones and high-boiling ethers.

11. Compositions according to Claim 10, **characterised in that** at least one solvent is selected from the group consisting of 3-fluorobenzotrifluoride, benzotrifluoride, dioxane, trifluoromethoxybenzene, 4-fluorobenzotrifluoride, 3-fluoropyridine, toluene, 2-fluorotoluene, 2-fluorobenzotrifluoride, 3-fluorotoluene, pyridine, 4-fluorotoluene, 2,5-difluorotoluene, 1-chloro-2,4-difluorobenzene, 2-fluoropyridine, 3-chlorofluorobenzene, 1-chloro-2,5-difluorobenzene, 4-chlorofluorobenzene, chlorobenzene, 2-chlorofluorobenzene, p-xylene, m-xylene, o-xylene, 2,6-lutidine, 2-fluoro-m-xylene, 3-fluoro-o-xylene, 2-chloro-benzotrifluoride, dimethylformamide, 2-chloro-6-fluorotoluene, 2-fluoroanisole, anisole, 2,3-dimethylpyrazine, bromobenzene, 4-fluoroanisole, 3-fluoroanisole, 3-trifluoromethylanisole, 2-methylanisole, phenetol, benzodioxole, 4-methylanisole, 3-methylanisole, 4-fluoro-3-methylanisole, 1,2-dichlorobenzene, 2-fluorobenzonitrile, 4-fluoroveratrol, 2,6-dimethylanisole, aniline, 3-fluorobenzonitrile, 2,5-dimethylanisole, 2,4-dimethylanisole, benzonitrile, 3,5-dimethylanisole, N,N-dimethylaniline, 1-fluoro-3,5-dimethoxybenzene, phenyl acetate, N-methylaniline, methyl benzoate, N-methylpyrrolidone, 3,4-dimethylanisole, o-tolunitrile, veratrol, ethyl benzoate, N,N-diethylaniline, propyl benzoate, 1-methylnaphthalene, butyl benzoate, 2-methylbiphenyl, 2-phenylpyridine and 2,2'-bitolyl.

12. Compositions according to one or more of Claims 1 to 11 **characterised in that** the boiling points of all solvents used are above 80°C.

13. Compositions according to one or more of Claims 1 to 12, **characterised in that** the solvent(s) used comprise(s) less than 10 ppm of triplet quencher.

14. Process for the preparation of compositions according to one or more of Claims 1 to 13, **characterised in that** they are prepared under an inert atmosphere and/or are prepared using degassed solvents and/or **in that** the compositions are degassed after preparation.

15. Process for the preparation of compositions according to Claim 14, **characterised in that** the composition is degassed for at least 15 minutes by passing an inert gas through the liquid composition.

16. Use of compositions according to one or more of Claims 1 to 13 for the production of layers of the organic semiconductor on a substrate.

17. Use of compositions according to one or more of Claims 1 to 13 for the production of organic electronic devices, in particular organic or polymeric light-emitting diodes, organic solar cells and organic laser diodes.

18. Use of compositions according to Claim 16 and/or 17 in a printing process.

19. Use according to Claim 18, **characterised in that** the printing process is ink-jet printing.

## Revendications

1. Compositions liquides comprenant au moins un semiconducteur organique qui émet de la lumière à partir de l'état de triplet, c'est-à-dire qui présente une phosphorescence et qui dispose de la capacité de former des films amorphes, et au moins un solvant organique, **caractérisées en ce que** les émetteurs de triplet qui sont utilisés sont des complexes métalliques qui émettent de la lumière à partir de l'état de triplet à température ambiante en électroluminescence et qui contiennent au moins un métal qui est sélectionné parmi le tungstène, le rhénium, le ruthénium, l'osmium, le rhodium, l'iridium, le palladium, le platine et l'or, et **en ce que** la teneur des désactivateurs de triplet dans la solution est inférieure à 10 ppm.

2. Compositions selon la revendication 1, **caractérisées en ce qu'**elles sont sous la forme d'une solution, d'une dispersion ou d'une émulsion.

3. Compositions selon la revendication 2, **caractérisées en ce que** la composition est sous la forme d'un système à une seule phase.

4. Compositions selon une ou plusieurs des revendications 1 à 3, **caractérisées en ce que** la solubilité du semiconducteur organique dans le solvant organique ou dans le mélange de solvants organiques à température ambiante et à pression atmosphérique est d'au moins 1 g/l.

5. Compositions selon une ou plusieurs des revendications 1 à 4, **caractérisées en ce qu'**au moins un composant du semiconducteur organique présente un poids moléculaire élevé.

6. Compositions selon une ou plusieurs des revendications 1 à 5, **caractérisées en ce que** le niveau de triplet du désactivateur de triplet est d'au moins 0,05 eV inférieur au niveau de triplet de l'émetteur de triplet.

7. Compositions selon une ou plusieurs des revendications 1 à 6, **caractérisées en ce que** le désactivateur de triplet est de l'oxygène moléculaire.

8. Compositions selon une ou plusieurs des revendications 1 à 7, **caractérisées en ce que** la teneur du désactivateur de triplet est inférieure à 1 ppm.

9. Compositions selon une ou plusieurs des revendications 1 à 8, **caractérisées en ce qu'**elles comprennent entre 0,01 et 20% en poids du semiconducteur organique.

10. Compositions selon une ou plusieurs des revendications 1 à 9, **caractérisées en ce que** les solvants sont sélectionnés parmi le groupe des solvants aromatiques mono- ou polysubstitués, en particulier les benzènes, les naphtalènes, les biphényls et les pyridines substitués, de préférence substitués par des groupes alkyle, lesquels peuvent également être fluorés, des atomes d'halogène, des groupes cyano, des groupes alcoxy, des groupes dialkylamino ou des groupes ester, ou des solvants non aromatiques sélectionnés parmi les dérivés d'acide formique, les N-alkylpyrrolidones et les éthers à point d'ébullition élevé.

11. Compositions selon la revendication 10, **caractérisées en ce qu'**au moins un solvant est sélectionné parmi le groupe constitué par 3-fluorobenzotrifluorure, benzotrifluorure, dioxane, trifluorométhoxy-benzène, 4-fluorobenzotrifluorure, 3-fluoropyridine, toluène, 2-fluorotoluène, 2-fluorobenzotrifluorure, 3-fluorotoluène, pyridine, 4-fluorotoluène, 2,5-difluorotoluène, 1-chloro-2,4-difluorobenzène, 2-fluoropyridine, 3-chlorofluorobenzène, 1-chloro-2,5-difluorobenzène, 4-chlorofluorobenzène, chlorobenzène, 2-chlorofluorobenzène, p-xylène, m-xylène, o-xylène, 2,6-lutidine, 2-fluoro-m-xylène, 3-fluoro-o-xylène, 2-chlorobenzotrifluorure, diméthylformamide, 2-chloro-6-fluorotoluène, 2-fluoroanisole, anisole, 2,3-diméthylpyrazine, bromo-benzène, 4-fluoroanisole, 3-fluoroanisole, 3-trifluorométhylanisole, 2-méthylanisole, phénétol, benzodioxole, 4-méthylanisole, 3-méthylanisole, 4-fluoro-3-méthylanisole, 1,2-dichlorobenzène, 2-fluorobenzonitrile, 4-fluorovératrol, 2,6-diméthylanisole, aniline, 3-fluorobenzonitrile, 2,5-diméthylanisole, 2,4-diméthylanisole, benzonitrile, 3,5-diméthylanisole, N,N-diméthylaniline, 1-fluoro-3,5-diméthoxy-benzène, acétate de phényle, N-méthylaniline, benzoate de méthyle, N-méthylpyrrolidone, 3,4-diméthylanisole, o-tolunitrile, vératrol, benzoate d'éthyle, N,N-diéthylaniline, benzoate de propyle, 1-méthyl-naphtalène, benzoate de butyle, 2-méthylbiphényle, 2-phénylpyridine et 2,2'-bitolyle.

12. Compositions selon une ou plusieurs des revendications 1 à 11, **caractérisées en ce que** les points d'ébullition de tous les solvants utilisés sont au-delà de 80°C.

13. Compositions selon une ou plusieurs des revendications 1 à 12, **caractérisées en ce que** le(s) solvant(s) utilisé(s) comprend/comprennent moins de 10 ppm de désactivateur de triplet.

14. Procédé pour la préparation de compositions selon une ou plusieurs des revendications 1 à 13, **caractérisé en ce qu'**elles sont préparées sous une atmosphère inerte et/ou sont préparées en utilisant des solvants dégazés et/ou **en ce que** les compositions sont dégazées après préparation.

15. Procédé pour la préparation de compositions selon la revendication 14, **caractérisé en ce que** la composition est dégazée pendant au moins 15 minutes en faisant passer un gaz inerte au travers de la composition liquide.

16. Utilisation de compositions selon une ou plusieurs des revendications 1 à 13 pour la production de couches du semiconducteur organique sur un substrat.

17. Utilisation de compositions selon une ou plusieurs des revendications 1 à 13 pour la production de dispositifs électroniques organiques, en particulier, de diodes émettrices de lumière organiques ou polymériques, de cellules solaires organiques et de diodes laser organiques.

18. Utilisation de compositions selon la/les revendication(s) 16 et/ou 17 au niveau d'un processus d'impression.

19. Utilisation selon la revendication 18, **caractérisée en ce que** le processus d'impression est une impression à jet d'encre.
